(19) Europäisches Patentamt

European Patent Office

Office européen des brevets

(11) Veröffentlichungsnummer: **0 310 591 B1**

(12) **EUROPÄISCHE PATENTSCHRIFT**

(45) Veröffentlichungstag der Patentschrift:
24.07.91 Patentblatt 91/30

(21) Anmeldenummer: 88890230.1

(22) Anmeldetag: 05.09.88

(51) Int. Cl.⁵: $C30B\ 7/10$, $C30B\ 29/14$, $C30B\ 29/10$

(54) Verfahren zum Züchten von homogenen Kristallen und Vorrichtung zur Durchführung des Verfahrens.

(30) Priorität: 04.09.87 AT 2242/87

(43) Veröffentlichungstag der Anmeldung:
05.04.89 Patentblatt 89/14

(45) Bekanntmachung des Hinweises auf die
Patenterteilung:
24.07.91 Patentblatt 91/30

(84) Benannte Vertragsstaaten:
BE CH DE FR GB IT LI NL SE

(56) Entgegenhaltungen:
EP-A- 0 057 773
FR-A- 2 559 166
GB-A- 654 486
JOURNAL OF CRYSTAL GROWTH, Band 80,
Nr. 1, Januar 1987, Seiten 133-148, Amsterdam, NL; J.C. JUMAS et al.: "Crystal growth of
berlinite, AIPO4: physical characterization and
comparison with quartz"

(73) Patentinhaber: AVL Gesellschaft für
Verbrennungskraftmaschinen und
Messtechnik mbH.Prof.Dr.Dr.h.c. Hans List
Kleiststrasse 48
A-8020 Graz (AT)

(72) Erfinder: Engel, Günter, Dipl.-Ing. Dr.
Dorfstrasse 58
A-8430 Leitring (AT)
Erfinder: Enko, Alfred
Keplerstrasse 87
A-8020 Graz (AT)
Erfinder: Krempl, Peter W., Dr.
Kainbach 211
A-8047 Graz/Ragnitz (AT)
Erfinder: Posch, Uwe, Dipl.-Ing.
Custozzagasse 1
A-8020 Graz (AT)

(74) Vertreter: Krause, Walter, Dr. Dipl.-Ing.
Postfach 200
A-1014 Wien (AT)

**Beschreibung**

Die Erfindung betrifft ein Verfahren zum Züchten von homogenen Kristallen aus einer in einem Zuchtbehälter vorliegenden hydrothermalen Zuchtlösung, wobei die Löslichkeit der Kristalle in der Zuchtlösung mit steigender Temperatur abnimmt (retrograde Löslichkeit) und eine Vorrichtung zur Durchführung des Verfahrens mit zumindest einem eine hydrothermale Zuchtlösung enthaltenden Zuchtbehälter mit Halterungen für Kristallrohmaterial und Kristallkeime, welcher über eine Rohrleitung mit zumindest einem weiteren Behälter verbindbar ist.

Unter "homogene Kristalle" sind in diesem Zusammenhang Kristalle gemeint, bei welchen Kristall und Kristallkeim dieselbe Kristallstruktur aufweisen und vorzugsweise aus demselben Material aufgebaut sind oder sich zumindest in den Gitterkonstanten weitgehend gleichen.

Beim Züchten von homogenen Kristallen bzw. Einkristallen aus hydrothermalen Zuchtlösungen mit retrograder Löslichkeit nach herkömmlichen Methoden treten sowohl beim Anfahren als auch beim Abstellen des Autoklaven bzw. Zuchtgefäßes Schwierigkeiten auf, welche mit der zunehmenden Löslichkeit der Kristalle bei abnehmender Temperatur zusammenhängen. Dadurch werden einerseits beim Anfahren des Autoklaven die Keimlinge aufgezehrt bzw. gehen beim Abstellen und zu langsamen Abkühlen des Autoklaven Teile der gebildeten Kristalle wieder in Lösung.

Nachteilig ist bei herkömmlichen Zuchtverfahren auch, daß während des oft einige Wochen dauernden Aufschlusses bzw. der Vorsättigung der Zuchtlösung der Zuchtbehälter für den eigentlichen Zuchtvorgang blockiert ist. Unter Aufschluß ist dabei jener Vorgang zu verstehen, bei welchem aus einer Mischung aus Metalloxid, Säure und Wasser die eigentliche Zuchtlösung, nämlich das Metallsalz, gelöst in einem Säurewassergemisch, entsteht.

Bei herkömmlichen Zuchtverfahren müssen meistens bei der Materialwahl für die Innenauskleidung des Autoklaven Kompromisse eingegangen werden, da diese den unterschiedlichsten thermodynamischen und mechanischen Belastungen, welche während des Aufschlusses und während des Zuchtvorganges herrschen, standhalten müssen.

Ein Verfahren der eingangs genannten Art bzw. eine Vorrichtung zur Durchführung dieses Verfahrens ist aus der US-PS 4382840 bekannt, wo ein Zuchtbehälter mit horizontal nebeneinander angeordneten Zucht- und Sättigungsbereich mit einem weiteren Behälter über eine Rohrleitung verbunden ist. In diesem zylinderförmig ausbebildeten Behälter, welcher geheizt werden kann, befindet sich die für den Zuchtprozeß benötigte Säure, welche nach Erhitzen mittels eines im Behälter geführten, nach außen abgedichteten Kolben in das Zuchtgefäß gepumpt und nach Beendigung des Zuchtvorganges aus dem Zuchtbehälter entfernt wird.

Nachteilig dabei ist jedoch, daß durch die heiße Säure, welche in den Zuchtbehälter gepumpt wird, ein Großteil der Keimlinge in Lösung geht und damit vernichtet wird, sowie daß bis zum eigentlichen Zuchtbeginn die zum Einstellen der Zuchtparameter benötigte Zeit zugewartet werden muß.

Daten über geeignete Zusammensetzungen einer Zuchtlösung, sowie geeignete Zuchttemperaturen, beispielsweise für $ABO_4$-Kristalle, wobei A aus der Gruppe Fe, Al, Ga und B aus der Gruppe P, As stammt, sind aus der DE-OS 3309598 bekannt. Verfahrensschritte bzw. Vorkehrungen, welche das Aufzehren von Kristallkeimen in der Zuchtlösung wirksam verhindern, gehen aus dieser Schrift nicht hervor.

In diesem Zusammenhang ist es bekannt geworden, die Zuchtlösung vor dem Einbringen in das Zuchtgefäß bei Temperaturen im Bereich der Zuchttemperatur vorzusättigen. Die wieder auf Raumtemperatur abgekühlte Zuchtlösung wird dann in das Zuchtgefäß gefüllt. Nachteilig dabei ist, daß retrograd lösliche Kristalle in Zuchtlösungen bei Raumtemperatur eine höhere Löslichkeit aufweisen als bei der Zuchttemperatur, sodaß beim Einbringen der Zuchtlösung bzw. bei Beendigung des Zuchtvorganges auch hier eine Beschädigung der Keimlinge bzw. der gebildeten Kristalle auftrifft. Zudem ist das Problem des Umpumpens der meist agressiven Zuchtlösung aus der genannten Schrift nicht zufriedenstellend gelöst, da dieser Vorgang zur Schonung der Kristallkeime und der Kristalle möglichst rasch erfolgen soll.

Aus der FR-PS 2559166 ist schließlich ein Verfahren zum Züchten von Aluminiumarsenat-Kristallen ($AlAsO_4$) bekannt geworden, bei welchem die Kristalle aus einer wäßrigen Arsensäurelösung gezogen werden. Da aufgrund der retrograden Löslichkeit von $AlAsO_4$-Kristallen, bei Temperaturen unterhalb der Sättigungstemperatur die Kristallphase in der Zuchtlösung nicht stabil ist und die $AlAsO_4$-Kristallkeime aufgelöst werden, bevor die Sättigungstemperatur erreicht wird, wird im Verfahren nach der genannten FR-PS vorgeschlagen, Berlinit-Keimlinge ($AlPO_4$) zu verwenden, welche dieselbe Kristallstruktur wir $AlAsO_4$ aufweisen und der Auflösung durch die Zuchtlösung weitgehend standhalten. Nachteiligerweise entstehen durch das genannte Verfahren keine homogenen Kristalle, da im Bereich des Keimlings — verursacht durch unterschiedliche Gitterkonstanten von $AlAsO_4$ und $AlPO_4$ — Gitterspannungen auftreten, welche nachteilige Auswirkungen auf die Eigenschaften des Kristalles haben. Zuden ist das Verfahren auf $AlAsO_4$ beschränkt, $AlPO_4$- oder $GaPO_4$-Kristalle sind beispielsweise damit nicht erzielbar.

2

Aufgabe der Erfindung ist es, ein Verfahren zum Züchten von Kirstallen aus hydrothermalen Zuchtlösungen vorzuschlagen, welches die angeführten Nachteile vermeidet und insbesondere ein Aufzehren der Kristallkeime bei Zuchtbeginn bzw. der gebildeten Kristalle nach dem Zuchtvorgang weitgehend verhindert.

Diese Aufgabe wird erfindungsgemäß dadurch gelöst, daß die Zuchtlösung außerhalb des Zuchtbehälters aufgeschlossen, vorgesättigt und bis zu einer Temperatur nahe der Sättigungstemperatur, vorgeheizt wird, daß die heiße Zuchtlösung für den eigentlichen Zuchtvorgang in den mit Kristallkeimen versehenen vorgeheizten Zuchtbehälter eingebracht und bis zu einer Temperatur, bei welcher das Kristallwachstum einsetzt, weiter erhitzt wird, sowie daß die heiße Zuchtlösung nach Beendigung des Zuchtvorganges rasch aus dem Zuchtbehälter entfernt wird. Durch diese Maßnahme wird der Zuchtbehälter mit relativ heißer Zuchtlösung beschickt und nach Beendigung des Zuchtvorganges kann diese wieder rasch aus dem Autoklaven entfernt werden, wodurch einerseits die sich im Autoklaven befindlichen Keimlinge bzw. fertigen Kristalle bestmöglich geschont werden und anderseits die Zeit bis zum Erreichen des Zuchtgleichgewichtes im Zuchtgefäß wesentlich verkürzt wird.

Erfindungsgemäß kann vorgesehen sein, daß die Zuchtlösung vor Einbringung in das die Kristallkeime beinhaltende Zuchtgefäß in einem diesem gleichartigen Gefäß äquilibriert wird bzw. daß die Zuchtlösung vor dem eigentlichen Zuchtvorgang und vor dem Einbringen der Kristallkeime in das Zuchtgefäß direkt im Zuchtgefäß äquilibriert wird.

Durch die der Zucht vorausgehende Äquilibrierung im Zuchtgefäß selbst bzw. in einem mit diesem verbundenen, weiteren Zuchtgefäß kann die Zuchtlösung bereits vor Zuchtbeginn mit den Innenwänden des Zuchtgefäßes bzw. mit den Einbauten in diesem in ein thermodynamisches Gleichgewicht kommen.

Das Ausmaß der Äquilibrierung wird erfindungsgemäß über während dieses Vorganges im Zuchtgefäß bzw. diesem gleichartigen Gefäß befindliche Sondenkeimlinge kontrolliert.

In einer Weiterbildung der Erfindung ist vorgesehen, daß die Zuchtlösung im Zuchtbehälter vorerst räumlich homogen bis zu einer Temperatur, bei welcher das Kristallwachstum einsetzt, aufgeheizt und unter Einstellung eines zeitlichen Temperaturgradienten langsam weiter erhitzt wird, sowie daß nach Verarmung der Zuchtlösung an Sättigungsmaterial der Sättigungsbereich gekühlt bzw. der Zuchtbereich weiter erhitzt wird, sodaß sich ein räumlicher, vorzugsweise vertikaler, Temperaturgradient ergibt. Bei gleichartig aufgebauten bzw. ausgestatteten Gefäßen können diese wechselweise zum Züchten der Kristalle und Aufschließen bzw. Äquilibrieren der Zuchtlösung verwendet werden.

Zur Vereinfachung der Prozeßbedingungen kann in einer Weiterbildung der Erfindung vorgesehen sein, daß die in das Zuchtgefäß einzubringende Zuchtlösung in einem Lagerbehälter unter Normaldruck erwärmt wird, und auf deren Weg in den Zuchtbehälter bis nahe an die Sättigungstemperatur weiter erhitzt wird, sowie nach Beendigung des Zuchtvorganges beim Zurückpumpen in den Lagerbehälter wieder abgekühlt wird. Ein Ausscheiden von Kristallmaterial an den Wänden des Lagerbehälters bzw. der Leitung zwischen Lagerbehälter und Zuchtbehälter wird dadurch weitgehend vermieden. Da für Aufschluß un Zucht unterschiedliche Behälter verwendet werden, können diese auch für den jeweiligen Zweck optimal ausgekleidet werden und das Zuchtgefäß ist in der Zeit, in der die Zuchtlösung aufgeschlossen bzw. vorgesättigt wird, nicht für Zuchtvorgänge blockiert.

Viele der benötigten hydrothermalen Zuchtlösungen sind sehr agressive Flüssigkeiten, beispielsweise die bei der Kristallzucht von Metallorthophosphaten in sauren Medien verwendeten Phosphorsäurelösungen, sodaß zum Umpumpen herkömmliche Pumpen nicht verwendet werden können und zusätzlich bei selbstansaugenden Pumpen der Dampfdruck der heißen Lösung unterschritten werden würde. Es ist deshalb erfindungsgemäß vorgesehen, daß die heiße Zuchtlösung mit Hilfe eines Druckmediums, vorzugsweise mit Druckluft, in den Zuchtbehälter eingebracht bzw. aus dem Zuchtbehälter entfernt wird, wobei von Vorteil ist, wenn die Zuchtlösung unter einem Druck, welcher über dem Dampfdruck der Zuchtlösung bei der Sättigungstemperatur liegt, in den Zuchtbehälter eingebracht wird bzw. wenn die Zuchtlösung unter jenem Druck, welcher über dem Dampfdruck der Zuchtlösung bei der Zuchtendtemperatur liegt, aus dem Zuchtbehälter entfernt wird. Dabei wird der Umpumpvorgang unter Überdruckverhältnissen durchgeführt, wobei der Druck des Druckmediums vorzugsweise um 0,5 bar über dem Systemdruck liegen kann. Durch den erhöhten Druck im Lagerbehälter können dort schon höhere Temperaturen erreicht werden, wodurch sich dann im Zuchtbehälter die für die Kristallzucht benötigte Temperatur rascher einstellen läßt.

So ist beispielsweise zum Züchten von Metallorthophosphat-Einkristallen, vorzugsweise von $GaPO_4$-Einkristallen erfindungsgemäß vorgesehen, daß in einem Lagerbehälter mit vorzugsweise Glasinnenwand ein Gemisch bestehend aus Metalloxid, $H_3PO_4$ und $H_2O$ bei Temperaturen zwischen 100 und 140°C in eine Zuchtlösung aus Metallorthophosphat in $H_3PO_4$ und $H_2O$ aufgeschlossen wird und daß ein Großteil der Temperaturdifferenz zwischen der Temperatur im Lagerbehälter und der im Zuchtbereich des Zuchtbehälters anfänglich herrschenden Temperatur < 200°C durch Aufheizen der Zuchtlösung beim Umpumpen ausgeglichen wird. Typischerweise wird die Zuchtlösung, beispielsweise bei der Herstellung von $GaPO_4$-Kristallen im

3

Lagerbehälter auf ca. 120°C bis 140°C vorgeheizt und mittels Druckluft vom Lagerbehälter in das Zuchtgefäß gepumpt, wobei die Zuchtlösung um 25 bis 30°C erwärmt in das auf 160°C geheizte Zuchtgefäß gelangt. Es ist natürlich auch möglich, der aufzuschließenden Zuchtlösung neben dem Metalloxid auch zumindest zum Teil das entsprechende Metallorthophosphat zuzusetzen.

Eine Vorrichtung zur Durchführung des Verfahrens mit zumindest einem eine hydrothermale Zuchtlösung enthaltenden Zuchtbehälter mit einer Heizeinrichtung, mit Halterungen für Kristallrohmaterial und Kristallkeime, sowie mit zumindest einem weiteren Behälter, welche Behälter über eine Rohrleitung lösbar verbunden sind, ist erfindungsgemäß dadurch gegeben, daß zumindest der Zuchtbehälter eine Tauchhebereinrichtung aufweist, welche Tauchhebereinrichtung über ein in die Zuchtlösung eintauchendes Tauchrohr und über einen Anschluß für ein Druckmedium verfügt, sodaß die Zuchtlösung durch Beaufschlagung mit dem Druckmedium von einem Behälter in den anderen überführbar ist. Als Druckmedium kann vorzugsweise Druckluft verwendet werden. Bei der erfindungsgemäßen Vorrichtung können durchaus mehrere als Lagerbehälter ausgeführte weitere Behälter mit mehreren Autoklaven verbunden sein, sodaß je nach Aufschlußzeit und Dauer einer allfälligen Vorsättigung in den Lagerbehältern, sowie Dauer des Zuchtvorganges im Zuchtbehälter letzterer zeitlich optimal ausgenützt ist. Da im unteren Teil des Zuchtbehälters, in welchem sich die Kristallkeime befinden, gleiche bzw. höhere Temperaturen herrschen als im oberen Teil des Zuchtbehälters, wo das Kristallrohmaterial angeordnet ist und der Zuchtbehälter in diesem Bereich beheizt wird, wird Kristallmaterial auch im Bereich des unteren Teils des Zuchtbehälters abgeschieden. Dadurch würden dort angeordnete Abflüsse allmählich zuwachsen, sodaß sich als Entleerungs- und Beschickungsvorrichtung eine mit Druckluft betriebene Tauchhebereinrichtung bewährt hat.

Einen wesentlichen Aspekt der Qualität von Kristallen, beispielsweise von $GaPO_4$-Kristallen, stellt die chemische Reinheit der Substanz und damit zusammenhängend diejenige der Zuchtlösung dar. Die Auswirkungen von Fremdatomen auch im ppm-Bereich, können bereits bei der Kristallisation merkbar sein, z.B. als Kristallisationshemmnis, Begünstigung von Domänen, Beeinflussung der Wachstumsraten bzw. der Wachstumskinetik.

Auch bei Verwendung der Kristalle als Resonatoren oder Druckwandler können Fremdatome unter Umständen sehr störend wirken und z.B. aufgrund der schlechten elektrischen Isolation zu hohen Verlustleistungen bei Resonatoren bzw. hohen unteren Grenzfrequenzen bei Meßelementen führen. Weitere Nachteile sind geringe Schwingungsgüten, geringe Temperaturschockempfindlichkeit und geringere Homogenität.

Es zeigt sich, daß beispielsweise der Tantalgehalt einer Lösung ziemlich linear von der Prozeßdauer in Tantal-Autoklaven abhängig ist. Daraus folgt, daß der Aufschluß der Zuchtlösung besser in einem Lagergefäß mit Glaswänden durchgeführt werden sollte. Wenn möglich, sollte auch die Vorsättigung im Lagergefäß erfolgen und nur die eigentliche Zucht im Tantal-Autoklaven. Da Tantal wie auch Silicium und Natrium in gewissem Umfang aus der Zuchtlösung in den Kristall eingebaut wird, muß der Gehalt dieser Elemente in der Zuchtlösung möglichst gering gehalten werden.

Der Siliciumgehalt von Zuchtlösungen in Glasgefäßen ist im Gegensatz dazu hauptsächlich von der maximal erreichten Temperatur und weniger von der Zuchtdauer abhängig, da im Lagerbehälter geringere Temperaturen herrschen als im Zuchtbehälter, ist es möglich, auch den Siliciumgehalt der Zuchtlösung gering zu halten. Durch unterschiedliche Auskleidung von Zucht- und Lagerbehältern kann somit der Fremdatomgehalt der Kristalle wesentlich vermindert werden. Für die Auskleidung der Behälter wird das für die jeweilige Zuchtlösung und die jeweiligen Zucht- bzw. Aufschlußparameter geeignetste Material verwendet, wobei insbesondere korrosionsbeständige, fluorhältige Kunststoffe wie PTFE, säurefeste Keramiken, Glas, sowie Edelmetalle in Frage kommen.

Die Einbauten des Zuchtgefäßes sind erfindungsgemäß so ausgestaltet, daß die im oberen Teil des Zuchtbehälters angeordneten, ein Sättigungsgerüst bildenden Halterungen für das Kristallrohmaterial und die im unteren Teil angeordneten Halterungen für die Kristallkeime, sowie ein zwischen oberen und unteren Teil des Zuchtbehälters angeordneten Baffle zentrale Öffnungen zum Einführen des Tauchrohres der Tauchhebereinrichtung aufweisen. Sowohl die Halterungen für das Kristallrohmaterial als auch jene für die Kristallkeime und das zwischen den unteren und oberen Teil angeordnete Baffle weisen zentrale Öffnungen auf, durch welche das Tauchrohr beim Füllen oder Entleeren des Autoklaven bis knapp über dem Boden des Zuchtgefäßes eingeführt werden kann. Während des Betriebes des Autoklaven befinden sich in dieser zentralen Öffnung Temperaturmeßelemente. Das in der Mitte angeordnete Baffle dient zum Aufrechterhalten des vertikalen Temperaturgradienten.

Zur besseren Anpassung der Vorrichtung an verschiedene Zuchtbedingungen kann erfindungsgemäß vorgesehen sein, daß die Halterungen für das Kristallrohmaterial und die Halterungen für die Kristallkeime modulartig aufgebaut sind und mitsamt dem Baffle durch gemeinsame im zusammengebauten Zustand stangenförmige Aufhängungen befestigbar sind, wobei erfindungsgemäß vorgesehen sein kann, daß die Einbauten des Zuchtgefäßes aus PTFE bestehen oder mit einem Fluorkunststoff beschichtet sind.

Das Aufheizen der Zuchtlösung auf die erforderliche Zuchttemperatur läßt sich erfindungsgemäß dadurch realisieren, daß sich in der Rohrleitung zwischen dem Zuchtbehälter und dem als Lagerbehälter zum Aufschließen und/oder Vorsättigen der Zuchtlösung ausgeführten weiteren Behälter ein Wärmetauscher befindet.

Die Erfindung wird im folgenden anhand eines Ausführungsbeispieles näher erläutert.

Es zeigen :

Fig. 1    ein Ausführungsbeispiel einer erfindungsgemäßen Vorrichtung in schematischer Darstellung und

Fig. 2 und 3    einen Zuchtbehälter der erfindungsgemäßen Vorrichtung geschnitten nach den Linien III-III bzw. II-II in den Fig. 2 und 3.

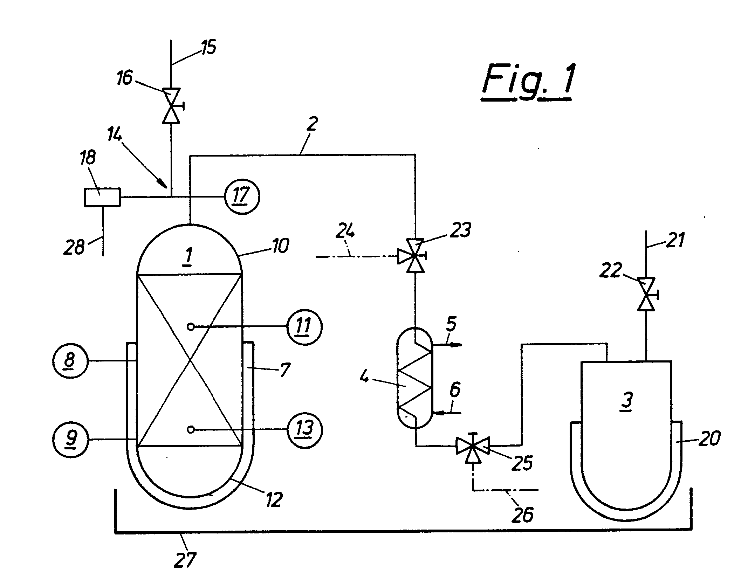

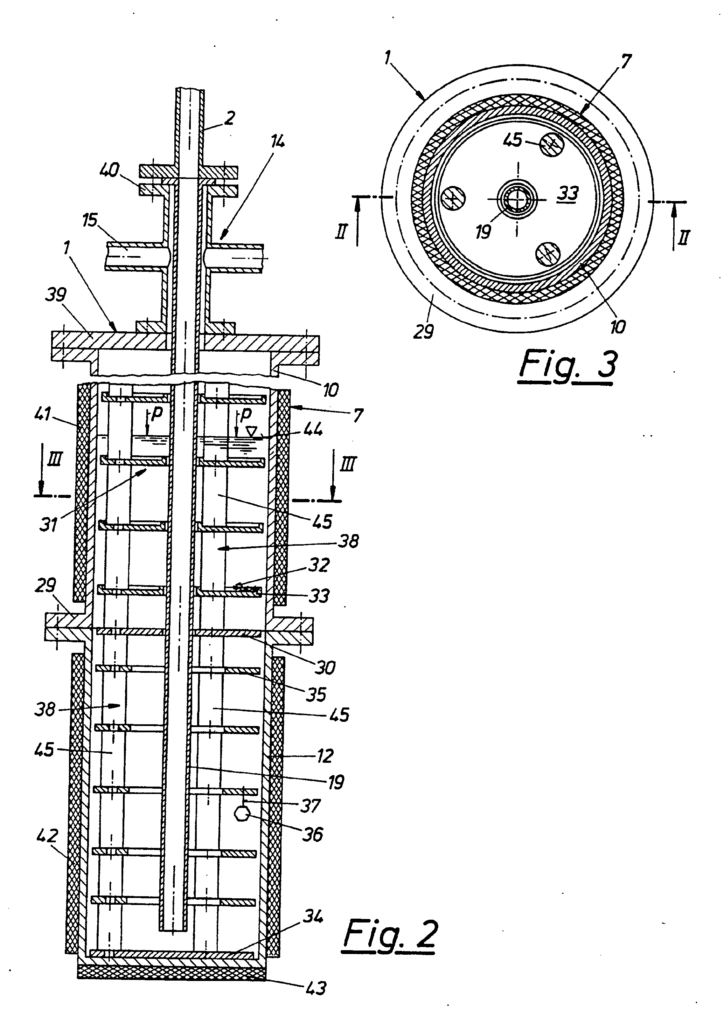

Die in Fig. 1 dargestellte Vorrichtung besteht aus einem Zuchtbehälter 1, welcher über eine Rohrleitung 2 mit einem Lagerbehälter bzw. weiteren Behälter 3 verbindbar ist. In der Rohrleitung 2 ist eine Wärmetauscheinrichtung, realisiert durch einen beispielsweise mit Siliconöl betreibbaren Wärmetauscher 4 mit den Anschlüssen 5 und 6, für das Wärmeträgermedium zwischengeschaltet. Der im Zuchtbehälter 1 benötigte Temperaturgradient wird durch die Heizeinrichtung 7 aufrechterhalten, welche aus mehreren aus Fig. 2 ersichtlichen Heizelementen bestehen kann, die durch zwei äußere, den einzelnen Heizelementen zugeordnete Temperaturmeßeinrichtungen 8 und 9 kontrolliert werden. Die Temperatur im Inneren des Zuchtbehälters 1 wird im oberen Teil 10 durch die Meßeinrichtung 11 und im unteren Teil 12 durch die Meßeinrichtung 13 erfaßt. Die Signale der einzelnen Temperaturmeßeinrichtungen werden von einer hier nicht dargestellten Prozeßsteuereinrichtung verarbeitet.

Die abnehmbare Rohrleitung 2 ist zum Umpumpen der Zuchtlösung aus dem Lagerbehälter 3 in den Zuchtbehälter 1 an eine Tauchhebereinrichtung 14 am Zuchtbehälter 1 angeschlossen. Die Tauchhebereinrichtung 14 weist einen Druckluftanschluß 15 mit Ventil 16, sowie in einem T-Stück eine Druckmeßeinrichtung 17 und als Sicherheitseinrichtung eine Berstscheibe 18 auf. Das Tauchrohr 19 der Tauchhebereinrichtung 14 ist im Detail in den Fig. 2 und 3 ersichtlich.

Der Lagerbehälter 3 verfügt ebenfalls über eine Heizeinrichtung 20 und einen Druckluftanschluß 21 mit Ventil 22. Es ist natürlich auch möglich, weitere Zuchtbehälter, beispielsweise über das Dreiwegventil 23 und Leitung 24 bzw. weitere Lagerbehälter über das Dreiwegventil 25 und Leitung 26 anzuschließen, um die Zuchtgefäß im Hinblick auf die jeweilige Zuchtdauer optimal auszunützen. Aus Sicherheitsgründen steht die Anlage in einem Auffangbecken 27. Der Abfluß 28 der Berstscheibe 18 mündet in ein hier nicht dargestelltes Kondensationsbecken.

Der in den Fig. 2 und 3 im Detail dargestellte Zuchtbehälter 1 wird für die Kirstallzucht von Metallorthophosphaten in sauren Medien (z.B. $GaPO_4$-Kristalle aus einer $GaPO_4$-$H_3PO_4$-$H_2O$-Lösung) verwendet, was jedoch nicht als Einschränkung der erfindungsgemäßen Vorrichtung auf diese Substanzgruppe gewertet werden soll, da die beschrieben Vorrichtung prinzipiell auch für andere Kristallzuchtprozesse aus hydrothermalen Lösungen mit retrograder Löslichkeit der Kristalle verwendet werden kann.

Der Zuchtbehälter 1 besteht im wesentlichen aus zwei PTFE-ausgekleideten Rohren, welche den oberen und unteren Teil 10 und 12 bilden und durch einen Flansch 29 verbunden sind. Im übrigen sind auch alle anderen, mit der Zuchtlösung in Kontakt kommenden Teile der Vorrichtung mit PTFE-Auskleidungen versehen.

Auf Höhe der Trennebene der beiden Rohre im Bereich der Flansches 29 befindet sich ein Baffle 30, mit dem die hydrodynamische Strömung der Zuchtlösung gezielt beeinflußt und der vertikale Temperaturgradient aufrecht erhalten werden kann. Im Baffle 30 können zusätzlich zu seiner zentralen Bohrung weitere Bohrungen zur Beeinflussung der Strömungsverhältnisse angeordnet sein.

Im oberen Teil 10 des Zuchtgefäßes 1 befindet sich das Sättigungsgerüst 31 mit der entsprechenden Menge an Kristallrohmaterial 32 in einzelnen, als kreisförmige Schalen ausgebildeten Halterungen 33.

Die im unteren Teil 12 des Zuchtbehälters 1 eingebaute Keimlingshalterung besteht im wesentlichen aus einer Grundplatte 34 und fünf ringförmigen Halterungen 35, die an drei Punkten mit Stäben 45 verschraubt werden. An jedem dieser ringförmigen Halterungen 35 werden vor Zuchtbeginn Kristallkeime 36, z.B. mit Drähten 37, befestigt.

Im Zentrum der Halterungen 33 und 35 und des Baffles 30 wird eine Bereich freigehalten, welcher einerseits ein Abpumpen der Zuchtlösung mit Hilfe des Tauchrohres 19 erlaubt und andererseits im Betrieb des Autoklaven die Temperaturmessung der Zuchtlösung mit den dort in verschiedenen Höhen angebrachten Temperaturmeßeinrichtungen 11 und 13 ermöglicht. Die Stäbe 45 bilden im zusammengebauten Zustand drei stangenförmige Aufhängungen 38, welche das Sättigungsgerüst 31, die Keimlingshalterungen 35 und das Baffle 30 tragen. Als Material für die Einbauten des Zuchtbehälters empfiehlt sich PTFE.

Der obere Teil 10 des Zuchtbehälters 1 ist mit einem Reduzierflansch 39 abgeschlossen, welcher die Tauchhebereinrichtung 14 mit dem Tauchrohr 19 und dem Druckluftanschluß 15 trägt. Beim Abpumpen der Zuchtlösung wirkt ein Druck p auf die Oberfläche 44 der Zuchtlösung, wodurch diese rasch aus dem Zuchtbehälter entfernt werden kann. Im Zuchtbetrieb wird die Leitung 2, z.B. ein mit PTFE ausgekleideter und mit Stahl ummantelter Schlauch vom Flansch 40 abgenommen und die Öffnung mit einem Blindflansch verschlossen.

Die Heizeinrichtung 7 umfaßt zwei ringförmige Heizelemente 41 und 42, wovon jede über eine eigene Temperaturregelung zur Aufrechterhaltung des vertikalen Temperaturgradienten verfügt. Zusätzlich kann noch ein Bodenheizelement 43 vorhanden sein.

Für die Temperaturmessung im Inneren durch die Meßeinrichtungen 11 und 13 sind zwei PTFE-umkleidete Mantelwiderstandsthermometer eingesetzt. Zur Abdichtung der Temperatursonden wird eine O-Ring-Quetschverschraubung eingesetzt, wobei als Korrosionsschutz des für die Druckführung verwendeten Flansches eine E-CTFE-Beschichtung verwendet wird. Diese Dichtungstechnik erlaubt eine stufenlose Höhenverschiebung der verwendeten Temperatursonden.

Im folgenden wird das Anfahren und Abstellen des Autoklaven anhand eines Beispieles beschrieben.

Die im Lagerbehälter 3 aufgeschlossene und ggf. vorgesättigte Zuchtlösung wird im Lagerbehälter auf ca. 120°C erhitzt und in den ca. 160° vorgeheizten Zuchtbehälter umgepumpt, wobei die Lösung mit Hilfe des Wärmetauschers 4 um 25 bis 30° erwärmt wird. Falls der Zuchtbehälter äquilibriert werden soll, befinden sich in diesem außer den Sondenkeimlingen vorerst keine Kristallkeime. Erst nachdem der Äquilibriervorgang abgeschlossen ist — was durch Wägen der Sondenkeimlinge ermittelt werden kann — wird die Zuchtlösung über die Tauchhebereinrichtung 14 in den Lagerbehälter 3 zurückgepumpt, wonach in den Zuchtbehälter die Kristallkeime eingesetzt werden. Nach dem Einpumpen der Zuchtlösung beginnt dann die eigentliche Kristallzucht, wobei zwischen Zuchtbereich und Sättigungsbereich in Zuchtbehälter ein Temperaturunterschied von 5 bis 30°C vorhanden sein kann.

Während des Betriebes dient ein Temperatur-Druck-Diagramm als Orientierung für den ordnungsgemäßen Prozeßablauf.

Beim Abstellung des Autoklaven wird die Heizung ausgeschaltet und der Zuchtbehälter bis auf ca. 140°C abgekühlt. Nach Ablassen des Überdruckes, beispielsweise in ein Wasserbad, wird der Tauchheber eingeführt und die Zuchtlösung gekühlt über den Wärmetauscher 4 in das Lagergefäß zurückgepumpt. Nach dem Trennen des oberen 10 vom unteren Teil 12 des Zuchtbehälters erfolgt die Demontage des Sättigungsgerüstes 31, des Baffles 30 und die Abnahme der Halterungen 35, wobei die Kristallausbeute entnommen wird.

**Patentansprüche**

1. Verfahren zum Züchten von homogenen Kristallen aus einer in einem Zuchtbehälter vorliegenden hydrothermalen Zuchtlösung, wobei die Löslichkeit der Kristalle in der Zuchtlösung mit steigender Temperatur abnimmt (retrograde Löslichkeit), **dadurch gekennzeichnet**, daß die Zuchtlösung außerhalb des Zuchtbehälters aufgeschlossen, vorgesättigt und bis zu einer Temperatur nahe der Sättigungstemperatur, vorgeheizt wird, daß die heiße Zuchtlösung für den eigentlichen Zuchtvorgang in den mit Kristallkeimen versehenen vorgeheizten Zuchtbehältern eingebracht und bis zu einer Temperatur, bei welcher das Kristallwachstum einsetzt, weiter erhitzt wird, sowie daß die heiße Zuchtlösung nach Beendigung des Zuchtvorganges rasch aus dem Zuchtbehälter entfernt wird.

2. Verfahren nach Anspruch 1, **dadurch gekennzeichnet**, daß die Zuchtlösung vor Einbringung in das die Kristallkeime beinhaltende Zuchtgefäß in einem diesem gleichartigen Gefäß äquilibriert wird.

3. Verfahren nach Anspruch 1, **dadurch gekennzeichnet**, daß die Zuchtlösung vor dem eigentlichen Zuchtvorgang und vor dem Einbringen der Kristallkeime in das Zuchtgefäß direkt im Zuchtgefäß äquilibriert wird.

4. Verfahren nach Anspruch 2 oder 3, **dadurch gekennzeichnet**, daß die Äquilibrierung über während dieses Vorganges im Zuchtgefäß bzw. diesem gleichartigen Gefäß befindliche Sondenkeimlinge kontrolliert wird.

5. Verfahren nach einem der Ansprüche 1 bis 4, **dadurch gekennzeichnet**, daß die Zuchtlösung im Zuchtbehälter vorerst räumlich homogen bis zu einer Temperatur, bei welcher das Kristallwachstum einsetzt, aufgeheizt und unter Einstellung eines zeitlichen Temperaturgradienten langsam weiter erhitzt wird, sowie daß nach Verarmung der Zuchtlösung an Sättigungsmaterial der Sättigungsbereich gekühlt bzw. der Zuchtbereich weiter erhitzt wird, sodaß sich ein räumlicher, vorzugsweise vertikaler, Temperaturgradient ergibt.

6. Verfahren nach einem der Ansprüche 1 bis 5, **dadurch gekennzeichnet**, daß die in das Zuchtgefäß einzubringende Zuchtlösung in einem Lagerbehälter unter Normaldruck erwärmt wird, und auf deren Weg in den Zuchtbehälter bis nahe an die Sättigungstemperatur weiter erhitzt wird.

7. Verfahren nach einem der Ansprüche 1 bis 6, **dadurch gekennzeichnet**, daß die heiße Zuchtlösung mit Hilfe eines Druckmediums, vorzugsweise mit Druckluft, in den Zuchtbehälter eingebracht bzw. aus dem Zuchtbehälter entfernt wird.

8. Verfahren nach Anspruch 7, **dadurch gekennzeichnet,** daß die Zuchtlösung unter einem Druck, welcher über dem Dampfdruck der Zuchtlösung bei der Sättigungstemperatur liegt, in den Zuchtbehälter eingebracht wird.

9. Verfahren nach Anspruch 7, **dadurch gekennzeichnet,** daß die Zuchtlösung unter jenem Druck, welcher über dem Dampfdruck der Zuchtlösung bei der Zuchtendtemperatur liegt, aus dem Zuchtbehälter entfernt wird.

10. Verfahren zum Züchten von Metallorthophosphat-Einkristallen, vorzugsweise von $GaPO_4$-Einkristallen, nach einem der Ansprüche 1 bis 9, **dadurch gekennzeichnet,** daß in einem Lagerbehälter mit vorzugsweise Glasinnenwand ein Gemisch bestehend aus Metalloxid, $H_3PO_4$ und $H_2O$ bei Temperaturen zwischen 100 und 140°C in eine Zuchtlösung aus Metallorthophosphat in $H_3PO_4$ und $H_2O$ aufgeschlossen wird und daß ein Großteil der Temperaturdifferenz zwischen der Temperatur im Lagerbehälter und der im Zuchtbereich des Zuchtbehälters anfänglich herrschenden Temperatur < 200°C durch Aufheizen der Zuchtlösung beim Umpumpen ausgeglichen wird.

11. Vorrichtung zur Durchführung des Verfahrens nach einem der Ansprüche 1 bis 10, mit zumindest einem eine hydrothermale Zuchtlösung enthaltenden Zuchtbehälter (1) mit einer Heizeinrichtung (7), mit Halterungen für Kristallrohmaterial und Kristallkeime, sowie mit zumindest einem weiteren Behälter (3), welche Behälter (1, 3) über eine Rohrleitung (2) lösbar verbunden sind, **dadurch gekennzeichnet,** daß zumindest der Zuchtbehälter (1) eine Tauchhebereinrichtung (14) aufweist, welche Tauchhebereinrichtung (14) über ein in die Zuchtlösung eintauchendes Tauchrohr (19) und über einen Anschluß (15) für ein Druckmedium verfügt, sodaß die Zuchtlösung durch Beaufschlagung mit dem Druckmedium von einem Behälter in den anderen überführbar ist.

12. Vorrichtung nach Anspruch 11, **dadurch gekennzeichnet,** daß die im oberen Teil (10) des Zuchtbehälters (1) angeordneten, ein Sättigungsgerüst (31) bildenden Halterungen (33) für das Kristallrohmaterial (32) und die im unteren Teil (12) angeordneten Halterungen (35) für die Kristallkeime (36), sowie ein zwischen oberen und unteren Teil (10, 12) des Zuchtbehälters (1) angeordnetes Baffle (30) zentrale Öffnungen zum Einführen des Tauchrohres (19) der Tauchhebereinrichtung (14) aufweisen.

13. Vorrichtung nach Anspruch 12, **dadurch gekennzeichnet,** daß die Halterungen (33) für das Kristallrohmaterial (32) und die Halterungen (35) für die Kristallkeime (36) modulartig aufgebaut sind und mitsamt dem Baffle (30) durch gemeinsame im zusammengebauten Zustand stangenförmige Aufhängungen (38) befestigbar sind.

14. Vorrichtung nach Anspruch 12 oder 13, **dadurch gekennzeichnet,** daß die Einbauten des Zuchtgefäßes (1) aus PTFE bestehen.

15. Vorrichtung nach einem der Ansprüche 11 bis 14, **dadurch gekennzeichnet,** daß sich in der Rohrleitung (2) zwischen dem Zuchtbehälter (1) und dem als Lagerbehälter zum Aufschließen und/oder Vorsättigen der Zuchtlösung ausgeführten weiteren Behälter (3) ein Wärmetauscher (4) befindet.

## Claims

1. A method of growing homogeneous crystals from a hydrothermal growing solution provided in a growing tank, the solubility of the crystals in the growing solution decreasing with an increase in temperature (retrograde solubility), wherein the growing solution is prepared, presaturated and pre-heated to a temperature close to saturation point outside of the growing tank, and wherein for the growing process proper the hot growing solution is added to the pre-heated growing tank provided with seed crystals, where it is further heated to a temperature at which crystal growth will set in, and wherein the hot growing solution is quickly drained from the growing tank at the end of the growing process.

2. A method according to claim 1, wherein the growing solution is equilibrated in a tank similar to the growing tank, before it is added to the growing tank containing the seed crystals.

3. A method according to claim 1, wherein the growing solution is equilibrated in the growing tank itself, before the growing process is initiated and the seed crystals are added to the growing tank.

4. A method according to claim 2 or 3, wherein equilibration is checked by means of probe seeds placed in the growing tank or a similar tank during this process.

5. A method according to any of claims 1 to 4, wherein the growing solution is heated in the growing tank in a spatially homogeneous way until a temperature is reached at which the crystals start growing, after which a temperature gradient over time is established and the heating process is continued slowly, and wherein — once the growing solution is depleted of saturation material — the saturation compartment is cooled down and/or the growing compartment is heated further, thus giving a spatial, preferably vertical, temperature gradient.

6. A method according to any of claims 1 to 5, wherein the growing solution to be added to the growing tank is heated in a storage tank at standard pressure, and is further heated close to saturation temperature on its way into the growing tank.

7. A method according to any of claims 1 to 6, wherein the hot growing solution is added to the growing tank, or removed therefrom, with the use of a pressure medium, preferably compressed air.

8. A method according to claim 7, wherein the growing solution is fed into the growing tank at a pressure above the vapour pressure of the growing solution at saturation point.

9. A method according to claim 7, wherein the growing solution is removed from the growing tank at a pressure above the vapour pressure of the growing solution at the temperature prevailing at the end of the growing process.

10. A method of growing monocrystals of metal orthophosphate, preferably GaPO4 monocrystals, according to any of claims 1 to 9, wherein, preferably in a storage tank with a glass lining, a mixture of metal oxide, H3PO4 and H2O is processed at 100-140°C to form a growing solution of metal orthophosphate in H3PO4 and H2O, and wherein most of the difference between the temperature in the storage tank and the initial temperature prevailing in the growing compartment of the growing tank (< 200°C) is balanced by heating the growing solution during pumping.

11. A device for use in the method of the invention according to any of claims 1 to 10, comprising at least one growing tank (1) containing a hydrothermal growing solution, with a heating unit (7) and fixtures for holding the raw material for the crystals and the crystal seeds, and further comprising at least one additional tank (3) — which tanks (1,3) may be connected by a removable tube (2) — , wherein a siphoning device (14) is used, at least for the growing tank (1), which siphoning device (14) is provided with a tube (19) immersed into the growing solution and a connection (15) for a pressure medium, permitting the growing solution to be transferred from one tank to the other upon application of the pressure medium.

12. A device according to claim 11, wherein the fixtures (33) holding the raw material (32) for the crystals, which are located in the upper part (10) of the growing tank (1) and form a saturation rack (31), and the fixtures (35) holding the seed crystals (36), which are located in the lower part (12) of the growing tank (1), as well as a baffle (30) placed between the upper and the lower part (10, 12) of the growing tank (1), all are provided with central openings into which the immersion tube (19) of the siphoning device (14) is inserted.

13. A device according to claim 12, wherein the fixtures (33) holding the raw material (32) for the crystals and the fixtures (35) for the seed crystals (36) are of a modular design and are mounted, together with the baffle (30), with the use of joint supporting elements (38) shaped like rods in the assembled state.

14. A device according to claim 12 or 13, wherein the built-in elements of the growing tank (1) are made of PTFE.

15. A device according to any of claims 1 to 14, wherein the tube (2) between the growing tank (1) and the additional tank (3) designed as a storage tank for preparation and/or pre-saturation of the growing solution, is provided with a heat exchanger (4).


**Revendications**

1. Procédé pour développer des cristaux homogènes à partir d'une solution hydrothermale contenue dans un cristallisoir, la solubilité des cristaux dans la solution diminuant quand la température augmente (solubilité rétrograde), caractérisé en ce qu'on prépare la solution nourricière en dehors du cristallisoir et on la préchauffe jusqu'à une température proche de la température de saturation, de sorte qu'on place la solution très chaude nourricière nécessaire au processus de développement proprement dit dans le cristallisoir préchauffé muni de germes cristallins, et on continue de chauffer jusqu'à une température à laquelle a lieu la croissance cristalline et en ce qu'on élimine rapidement du cristallisoir la solution très chaude à la fin du processus de développement.

2. Procédé selon la revendication 1, caractérisé en ce qu'on stabilise la solution nourricière avant l'introduction dans le cristallisoir contenant les germes cristallins, dans un récipient qui lui est identique.

3. Procédé selon la revendication 1, caractérisé en ce qu'on stabilise directement dans le cristallisoir la solution nourricière avant le processus de développement proprement dit et avant l'introduction de germes cristallins dans le cristallisoir.

4. Procédé selon la revendication 2 ou 3, caractérisé en ce qu'on contrôle la stabilisation pendant ce processus dans le cristallisoir ou dans le récipient qui lui est similaire à l'aide de germes sondes.

5. Procédé selon l'une des revendications 1 à 4, caractérisé en ce qu'on chauffe la solution nourricière dans le cristallisoir tout d'abord de manière homogène jusqu'à une température où se produit la croissance cristalline et en ajustant un gradient de température dans le temps on continue de chauffer lentement, et en ce qu'après appauvrissement de la solution nourricière en matériau saturant on refroidit la zone de saturation ou on continue de chauffer la zone de cristallisation de façon à obtenir un gradient de température de préférence vertical dans l'espace.

6. Procédé selon l'une des revendications 1 à 5, caractérisé en ce qu'on chauffe la solution nourricière à introduire dans le cristallisoir dans un réservoir à pression atmosphérique et qu'on la réchauffe encore sur le trajet vers le cristallisoir jusqu'aux environs du point de saturation.

7. Procédé selon l'une des revendications 1 à 6, caractérisé en ce qu'on introduit dans le cristallisoir ou bien on extrait du cristallisoir la solution nourricière très chaude à l'aide d'un milieu de pression, de préférence avec de l'air comprimé.

8. Procédé selon la revendication 7, caractérisé en ce qu'on transfère la solution nourricière dans le cristallisoir sous une pression qui est supérieure à la pression de vapeur de la solution nourricière à température de saturation.

9. Procédé selon la revendication 7, caractérisé en ce qu'on vidange la solution nourricière sous une pression qui est supérieure à la pression de vapeur de la solution nourricière à la température de fin de cristallisation.

10. Procédé pour faire développer des monocristaux d'orthophosphates métalliques de préférence des monocristaux de $GaPO_4$ selon l'une des revendications 1 à 9, caractérisé en ce qu'on dissout dans un réservoir de préférence à parois internes en verre, un mélange constitué d'oxyde métallique, $H_3PO_4$ et $H_2O$ à des températures comprises entre 100 et 140°C dans une solution nourricière d'orthophosphate métallique dans $H_3PO_4$ et $H_2O$ et en ce qu'on compense une grande partie de la différence de température entre la température dans le réservoir et celle régnant au début dans la zone de cristallisation du cristallisoir < 200°C par réchauffage de la solution nourricière lors du transfert par pompage.

11. Dispositif pour réaliser le procédé selon l'une des revendications 1 à 10, avec au moins un cristallisoir (I) contenant une solution nourricière hydrothermale, avec un dispositif de chauffage (7), avec des supports pour le matériau brut de cristal et les germes cristallins, ainsi qu'au moins un autre récipient (3), ces récipients étant reliés par une tuyauterie (2) démontable, caractérisé en ce que le cristallisoir (1) présente au moins un dispositif de trempage relevable (14), comprenant un tube plongeant (19) dans la solution nourricière et une connexion (15) pour un moyen de pression, de façon à pouvoir transférer d'un récipient dans l'autre la solution nourricière sous l'effet du moyen de pression.

12. Dispositif selon la revendication 11, caractérisé en ce que les supports (33) formant une armature de saturation (31), disposés dans la partie supérieure (10) du cristallisoir (1) pour le matériau brut de cristal (32) et les supports (35) disposés dans la partie inférieure (12) pour les germes cristallins (36), ainsi qu'une chicane (30) placée entre les parties supérieure et inférieure (10, 12) du cristallisoir (1) présentent des orifices centraux pour introduire le tube plongeant (19) du dispositif de trempage relevable (14).

13. Dispositif selon la revendication 12, caractérisé en ce que les supports (33) pour le matériau brut de cristal (32) et les supports pour les germes cristallins (36) sont de construction modulaire et en ce qu'avec la chicane (30) on peut les fixer à des suspensions (38) en forme de tiges une fois montées.

14. Dispositif selon les revendications 12 ou 13, caractérisé en ce que les chicanes du cristalliaoir (1) sont en PTFE.

15. Dispositif selon l'une des revendications 11 à 14, caractérisé en ce que sur la tuyauterie (2), entre le cristallisoir (1) et l'autre récipient (3) réalisé en réservoir pour dissoudre et/ou présaturer la solution nourricière, il y a un échangeur de chaleur (4).

_Fig. 1_

_Fig. 3_

_Fig. 2_